(19) Europäisches Patentamt
European Patent Office
Office européen des brevets

(11) **EP 1 811 661 A1**

(12) **EUROPEAN PATENT APPLICATION**

(43) Date of publication:
**25.07.2007 Bulletin 2007/30**

(51) Int Cl.:
*H03H 9/24* (2006.01)    *G01C 19/56* (2006.01)

(21) Application number: **07100772.8**

(22) Date of filing: **18.01.2007**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **18.01.2006 US 275593**

(71) Applicant: Honeywell International Inc.
**Morristown, NJ 07962 (US)**

(72) Inventors:
• PLATT, William P
  Forest Lake, MN 55025 (US)
• KNOWLES, Gary R
  Ham Lake, MN 55304 (US)
• GLENN, Max C
  Chanhassen, MN 55317 (US)

(74) Representative: **Haley, Stephen**
**Gill Jennings & Every LLP**
**Broadgate House**
**7 Eldon Street**
**London EC2M 7LH (GB)**

(54) **Frequency Shifting of Rotational Harmonics in MEMS Devices**

(57) Structures and methods for frequency shifting rotational harmonics in MEMS devices are disclosed. An illustrative MEMS device can include a substrate, a sense electrode coupled to the substrate, and a proof mass adjacent to the sense electrode. A number of non-uniformly dispersed holes or openings on the proof mass can be configured to alter the distribution of mass within the proof mass. During operation, the presence of the holes or openings alters the frequency at which the proof mass rotates about a centerline in a rotational mode, reducing the introduction of harmonics into the drive and sense systems.

*Figure 4*

EP 1 811 661 A1

## Description

Field

The present invention relates generally to the field of microelectromechanical systems (MEMS). More specifically, the present invention pertains to frequency shifting of rotation harmonics in MEMS devices.

Background

Microelectromechanical systems (MEMS) integrate electrical and mechanical devices onto a single substrate using microfabrication techniques. The electrical components forming such systems are typically fabricated using integrated circuit processes common in the semiconductor industry, while the mechanical components are often fabricated using micromachining processes that are compatible with the integrated circuit processes. This combination makes it possible to fabricate an entire MEMS device on a chip using standard manufacturing processes. Examples of devices that have been constructed using MEMS technology include gyroscopes, accelerometers, actuators, resonators, switches, valves, pumps, and optical elements.

One common application of MEMS technology is the design and manufacture of inertial sensing devices for the detection and sensing of changes in motion in moving objects. In the design of navigational and communications systems, for example, such devices are useful in sensing slight variations in linear and/or rotational motion of an object traveling through space. In automotive systems, such devices can be used to sense tire rotation in antilock braking systems (ABS), and to detect the presence of a collision in airbag deployment systems. Typically, such motion is sensed by detecting and measuring displacement of a structure such as a number of proof masses, cantilevered beams and/or interdigitated comb fingers. In an inertial sensor employing a MEMS-type gyroscope or accelerometer, for example, a number of proof masses can be used to sense displacement and/or acceleration in response to movement of the device about a rate axis. In some designs, one or more of the gyroscopes and/or accelerometers can be provided as part of an inertial measurement unit (IMU) that can be used to measure motion and acceleration in multiple dimensions.

In a typical MEMS-based sensor such as a tuning-fork gyroscope (TFG), a set of vibrating proof masses are used to sense angular rate through the generation and detection of Coriolis forces. A number of interdigitated comb fingers can be configured to apply a force to the proof masses in a motor mode back and forth along a drive axis when electrostatically charged with a time varying signal from a drive voltage source. A number of suspension springs or other flexural elements are typically used to constrain motion of each proof mass in a particular direction above an underlying support substrate.

A sense electrode or other sensing means disposed on the substrate can be used to sense and measure motion of the proof masses along a sense axis of the gyroscope. As each proof mass moves back and forth above the substrate, the Coriolis forces resulting from conservation of momentum of the mass as it rotates about the rate axis causes the spacing between each proof mass and sense electrode to vary, resulting in a concomitant change in capacitance. The Coriolis force drives a second mode of oscillation, sometimes referred to as the sense mode. By measuring the capacitance between each proof mass and corresponding sense electrode, a measure of the rotational motion and/or acceleration of the moving body can be ascertained.

One source of errors in MEMS-type inertial sensors can result from the oscillation of the proof masses in vibrational modes different from the desired motor and sense modes. Typically, the proof mass oscillation is maintained at a particular amplitude and/or frequency. Examples of undesired vibration modes that can result from a vibrating frequency within the control loop pass band of the sensor may include a hula mode, in which each of the proof masses move in tandem along the drive axis, and a trampoline mode, in which each of the proof masses move in tandem along the sense axis direction orthogonal to the drive axis. Other common vibrational modes include a twist mode and a flip-flap mode.

In one undesired mode of operation often referred to as a rotational mode, rotation of each of the proof masses is induced about a central axis of the proof mass that is substantially parallel to sense axis of the sensor. Such undesired rotation may occur, for example, when the oscillation frequency of the proof masses is within the control loop pass band used by the drive electronics to drive the proof masses in their motor mode. In some cases, such rotation may also result from imperfections in the manufacturing process used to form the proof masses, suspension springs and/or comb fingers as well as the drive electronics used to drive the proof masses. When present, such rotation can affect the ability of the device to start operating on the desired motor mode, and may introduce rotational harmonics into the drive and sense systems that can interfere with the operation of the device.

Summary

The present invention pertains to frequency shifting of rotational harmonics in MEMS devices such as gyroscopes or accelerometers. A MEMS device in accordance with an illustrative embodiment can include a substrate, at least one sense electrode coupled to the substrate, and at least one proof mass adjacent to the at least one sense electrode. A number of non-uniformly dispersed holes or openings within the proof mass can be configured to change the distribution of mass about a mass centerline perpendicular to the direction of a motor drive axis of the proof mass. The holes or openings can be disposed in a pattern or array at or near each end of the proof mass. In some embodiments, the holes or openings may extend through the entire thickness of the proof mass. In other embodiments, the holes or openings may extend through only the top and/or bottom portions the proof mass.

The presence of the holes or openings on the proof mass can be utilized to reduce the mass at or near the ends of the proof mass, reducing the moment of inertia of the proof mass about its centerline. Such reduction in moment of inertia increases the frequency at which the proof mass rotates in its rotational mode, reducing or eliminating the introduction of rotational harmonics into the drive and sense systems. In some embodiments, for example, the distribution of the holes or openings can be configured to increase the rotational mode frequency of the proof mass to a level above the control loop pass band used by the drive system to drive the proof mass. In other embodiments, the holes or openings can be distributed so as to decrease the rotational mode frequency of the proof mass to compensate for other undesired vibration modes.

Brief Description of the Drawings

Figure 1 is a top schematic view of an illustrative MEMS-type tuning fork gyroscope;

Figure 2 is a top schematic view showing the configuration of one of the proof masses of Figure 1 in greater detail, wherein the proof mass includes a number of uniformly dispersed through-holes;

Figure 3 is a side schematic view showing the operation of the illustrative gyroscope of Figures 1-2;

Figure 4 is a top schematic view of a portion of a proof mass structure in accordance with an illustrative embodiment having a number of non-uniformly dispersed holes or openings;

Figure 5 is a cross-sectional view of the proof mass along line 5-5 in Figure 4 showing the holes or openings extending through the entire thickness of the proof mass;

Figure 6 is another cross-sectional view of the proof mass showing the holes or openings extending through only a top portion of the proof mass;

Figure 7 is another cross-sectional view of the proof mass showing the holes or openings extending through only a top and bottom portion of the proof mass;

Figure 8 is a top schematic view of a portion of a proof mass structure in accordance with another illustrative embodiment having an array of holes or openings;

Figure 9 is a top schematic view of a portion of a proof mass structure in accordance with another illustrative embodiment having a staggered pattern or array of holes or openings;

Figure 10 is a top schematic view of a portion of a proof mass structure in accordance with another illustrative embodiment having an array of holes or openings increasing in size towards each proof mass end;

Figure 11 is a top schematic view of a portion of a proof mass structure in accordance with another illustrative embodiment having a number of slots;

Figure 12 is a top schematic view of an illustrative accelerometer including a proof mass with a number of non-uniformly dispersed holes or openings; and

Figure 13 is a top schematic view of a portion of a proof mass structure in accordance with another illustrative embodiment having an array of holes or openings decreasing in size towards each proof mass end.

Detailed Description

The following description should be read with reference to the drawings, in which like elements in different drawings are numbered in like fashion. The drawings, which are not necessarily to scale, depict selected embodiments and are not intended to limit the scope of the invention. Although examples of construction, dimensions, and materials are illustrated for the various elements, those skilled in the art will recognize that many of the examples provided have suitable alternatives that may be utilized. While the various examples provided herein discuss the frequency shifting of rotational harmonics in MEMS-type gyroscopes and accelerometers, it should be understood that the techniques discussed herein can be utilized in any number of different devices employing structures susceptible to rotational modes. Examples of other MEMS devices may include, but are not limited to, inertial measurement units (IMU's), actuators, resonators, switches, valves, pumps, pressure sensors, temperature sensors, and optical elements.

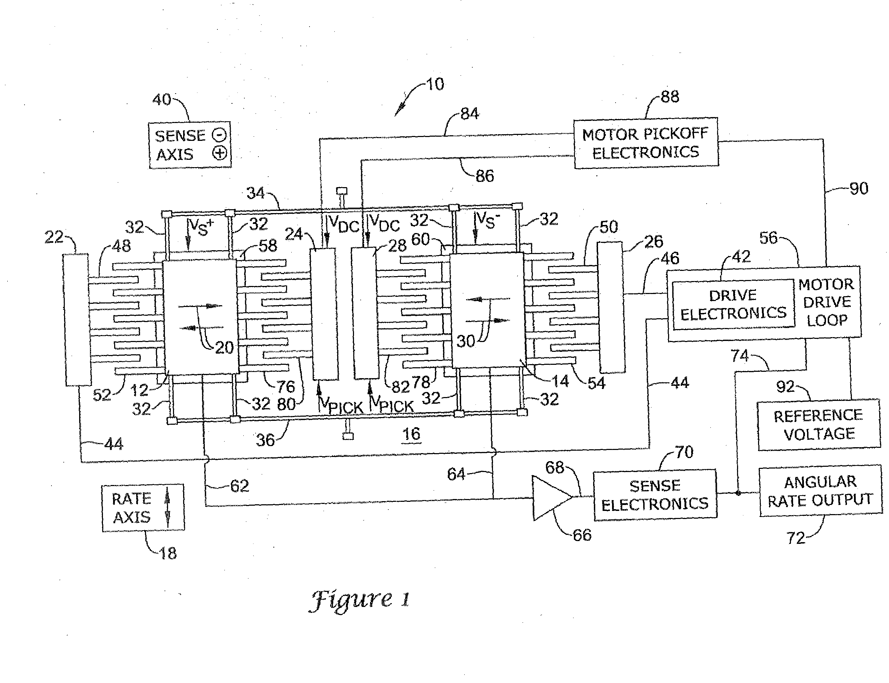

Referring now to Figure 1, a top schematic view of a MEMS-type gyroscope 1 0 will now be described. Gyroscope 10, illustratively an in-plane tuning fork gyroscope (TFG), includes a first proof mass 12 and second proof mass 14, each of which are adapted to move back and forth above an underlying support substrate 16 in a drive plane orthogonal to an input or rate axis 18 of the gyroscope 10 in which inertial motion is to be determined. As indicated generally by the right/left set of arrows 20, the first proof mass 12 can be configured to move back and forth above the support substrate 16 between a first drive electrode 22 and a first motor pickoff comb 24, both of which remain stationary above the support substrate 16 to limit movement of the first proof mass 12. The second proof mass 14, in turn, can be configured to move back and forth above the support substrate 16 in a similar manner between a second drive electrode 26 and a second motor pickoff comb 28 but 180 degrees out-of-phase with the first proof mass 12, as indicated generally by the left/right set of arrows 30.

The first and second proof masses 12,14 can be constrained in one or more directions above the underlying support structure 16 using one or more suspension springs. As shown in Figure 1, for example, the first proof mass 12 can be anchored or otherwise coupled to the underlying support substrate 16 using a first set of four suspension springs 32, which are attached to a number of cross beams 34,36 formed over the substrate 16. In similar fashion, the second proof mass 14 can be anchored to the underlying support substrate 16 using a similar set of four springs 32 also attached to the cross beams 34,36, as shown. While four suspension springs 32 are depicted, it is contemplated that any number of suspensions may be utilized.

In use, the suspension springs 32 can be configured to isolate movement of the first and second proof masses 12,14 to the direction indicated generally by the right/left set of arrows 20,30 to reduce undesired motion in the direction of the rate axis 18 and along a sense axis 40 of the gyroscope 10. In addition to supporting the proof masses 12,14 above the support substrate 16, the suspension springs 32 and cross beams 34,36 can also be configured to provide a restorative force to the proof masses 12,14 as they are driven through their zero point during each actuation cycle.

The gyroscope 10 may include drive electronics 42 that can be used to induce motor mode motion of the proof masses 12,14 along the drive axes 20,30. The drive electronics 42 can be configured to apply a first drive voltage signal 44 to the first drive electrode 22 for inducing movement of the first proof mass 12, and a second drive voltage signal 46 applied to the second drive electrode 26 for inducing movement of the second proof mass 14. In the illustrative embodiment depicted, each of the drive electrodes 22,26 include a number of comb fingers 48,50, which can be interdigitated with a respective number of comb fingers 52,54 extending outwardly from each proof mass 12,14. When charged via the drive voltage signals 44,46, the comb fingers 48,50 of each drive electrode 22,26 produce an electrostatic attractive force between each set of interdigitated comb fingers 48,50,52,54, causing the comb fingers 48,50,52,54 to move with respect to each other. The voltage signals 44,46 applied to each drive electrode 22,26 can be time-varying, and are out-of-phase with respect to each other, which in conjunction with the suspension springs 32, causes the first and second proof masses 12,14 to move back and forth in opposition to each other above the support substrate 16. In some embodiments, for example, the voltage signals 44,46 may each be AC signals that are maintained 180 degrees out-of-phase with each other. Alternatively, and in other embodiments, the voltage signals 44,46 may be DC signals whose magnitude and/or polarity varies over time. In either embodiment, control of the frequency and amplitude characteristics can be accomplished via the drive electronics 42.

The drive voltages signals 44,46 can be configured to drive the proof masses 12, 14 in a differential mode of operation above the underlying support substrate 16. In some embodiments, the drive voltage signals 44,46 applied to each drive electrode 24,28 can be regulated via a motor drive loop 56, which can comprise a closed loop system that receives feedback signals from various sense and motor pickoff electronics 70,88 of the gyroscope 10, as discussed in greater detail below.

A pair of sense electrodes 58,60 can be provided as part of the sensing system to detect and measure the out-of-plane deflection of the first and second proof masses 12,14 in the sense mode direction 40 as a result of gyroscopic movement about the rate axis 18. The sense electrodes 58,60 can be formed from a suitable material such as silicon that is electrically conductive with the material used to form the first and second proof masses 12,14 (e.g. a silicon-doped conductor), allowing the charge produced on the sense electrodes 58,60 vis-à-vis a sense bias voltage $V_s$ to be transmitted to the proof mass 12,14. In the illustrative embodiment depicted in Figure 1, the sense electrodes 58,60 can each include a thin, rectangular-shaped electrode plate positioned underneath the proof masses 12,14 and oriented in a manner such that an upper face of each sense electrode 58,60 is positioned vertically adjacent to and parallel with the underside of the respective proof mass 12,14, forming a parallel plate capacitor. While stationary sense electrodes 58,60 are depicted in Figure 1, it should be understood that moving sense electrodes may also be utilized, depending on the particular configuration of the MEMS device.

During operation, if an angular rate (e.g. an aircraft turning) is applied to the gyroscope 10 along the rate axis 18 while the proof masses 12,14 are moving along the drive motor axis 20,30, a Coriolis force can be detected in the direction of the sense axis 40. Typically, a DC and/or an AC bias voltage $V_s$ is applied to each of the sense electrodes 58,60 so that motion of the proof masses 12,14 in the sense mode changes the capacitance. In other embodiments, however, a DC and/or AC bias voltage $V_s$ may be applied to the proof masses 12,14 while the sense electrode is maintained at virtual ground. The capacitance between the proof mass 12,14 and each respective sense electrode 58,60 is then utilized in sensing motion along the sense axis 40, which as shown in Figure 1, can be fed as a sense signal 62,64 to an amplifier 66. The amplified signal 68 from the amplifier 66 is then fed to various sense electronics 70 to detect and measure changes in capacitance as the proof masses 12,14 move towards and/or away from the sense electrodes 58,60. In some embodiments, the sense electronics 70 can also be configured to detect changes in capacitance as the proof masses 12,14 move relative to the drive electrodes 22,26 and the pickoff combs 24,28.

The sense electronics 70 can be configured to output a rate signal 72 indicative of the rotation of the gyroscope 10 about the rate axis 18. In some embodiments, for example, the sense electronics 70 can be configured to output the rate signal 72 to a navigational guidance system for the control of an aircraft, missile, or other moving object. In those embodiments in which the gyroscope 10 is part of an inertial measurement unit (IMU), the rate signal 72 can be provided along with one or more other such signals to provide an indication of angular rate in multiple dimensions, if desired. In some embodiments, the motor drive loop 56 can be configured to receive a feedback signal 74 from the sense electronics 70, which can be used to control the drive voltage signals 44,46 based at least in part on the sense signals 62,64 received from the sense electrodes 58,60.

A motor bias voltage $V_{DC}$ can be provided across the first and second motor pickoff combs 24,28 to detect and/or measure displacement of the proof masses 12,14 induced via the drive voltage signals 44,46. A motor pickoff voltage $V_{PICK}$ resulting from movement of a number of outwardly extending comb fingers 76,78 on the first and second proof masses 12,14 relative to the comb fingers 80,82 on the first and second motor pickoff combs 24,28 can be used to detect motion of the first and second proof masses 12,14. The motor pickoff signals 84,86 resulting from the motor pickoff voltage $V_{PICK}$ can then be fed to motor pickoff electronics 88, which can include various amplifiers and inverters to provide an output signal 90 that represents the amplitude of the motor mode of the proof masses 12, 14. The output signals 90 can then be fed back to the motor drive loop 56 for further control by the drive electronics 42. In some embodiments, a reference voltage 92 can be input into the control loop 56 for use in automatic gain control of the drive signals 44,46 outputted by the drive electronics 42, if desired.

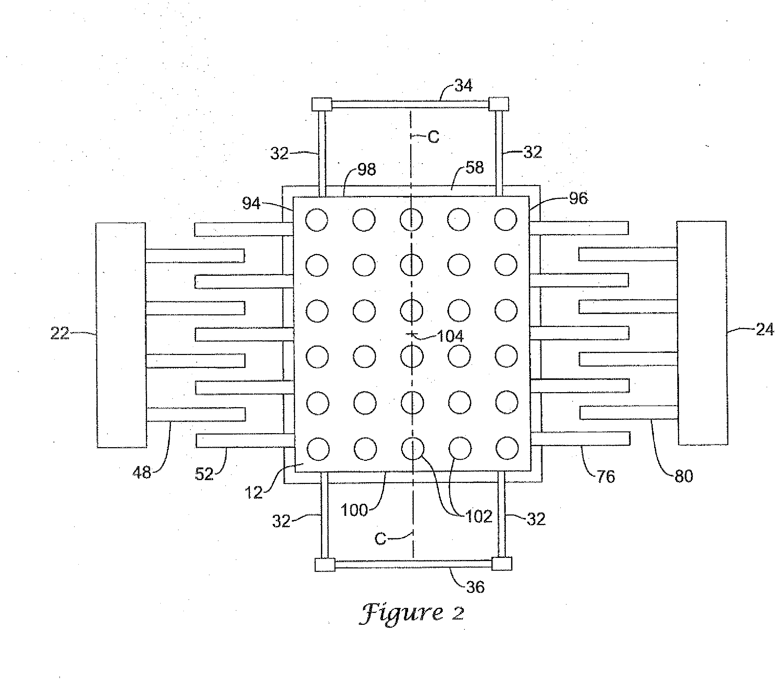

Figure 2 is a top schematic view showing the configuration of one of the proof masses 12 of Figure 1 in greater detail. As can be further seen in Figure 2, each proof mass 12 can include a thin plate or other suitable structure having a first end 94, a second end 96, a first side 98, and a second side 100. Extending outwardly from the first end 94 of the proof mass 12 are the left set of comb fingers 52, which are interdigitated with the drive comb fingers 48 for driving the motor mode of the proof mass 12. Furthermore, extending outwardly from the second end 96 of the proof mass 12 are the right set of comb fingers 76, which are interdigitated with the motor pickoff comb fingers 80 for sensing motion of the proof mass 12. The second proof mass 14 can be configured similar to the first proof mass 12, and is thus not shown for sake of clarity. While four comb fingers 52,76 are shown extending from each end 94,96 of the proof mass 12, it should be understood that a greater or lesser number of comb fingers could be utilized, if desired. In addition, it should be understood that the number and configuration of the drive comb fingers 48 and/or motor pickoff comb fingers 80 may also vary.

In the illustrative gyroscope 10 depicted in Figure 2, the proof mass 12 further includes a number of through-holes 102 for reducing the aerodynamic drag of the proof mass 12 as it oscillates back and forth above the underlying substrate 16. As shown in Figure 2, the through-holes 102 are uniformly dispersed both lengthwise (*i.e.* left-to-right) between the first and second ends 94,96 of the proof mass 12, and widthwise (*i.e.* top-to-bottom) between the first and second sides 98,100 of the proof mass 12. In this configuration, the mass of the proof mass 12 is arranged evenly throughout the structure with the distribution of the mass being substantially the same at the center portion 104 of the proof mass 12 than at the ends 94,96 and sides 98,100 thereof. A centerline C extending through the center portion 104 perpendicular to the direction of the motor drive axis defines a central axis of the proof mass 12.

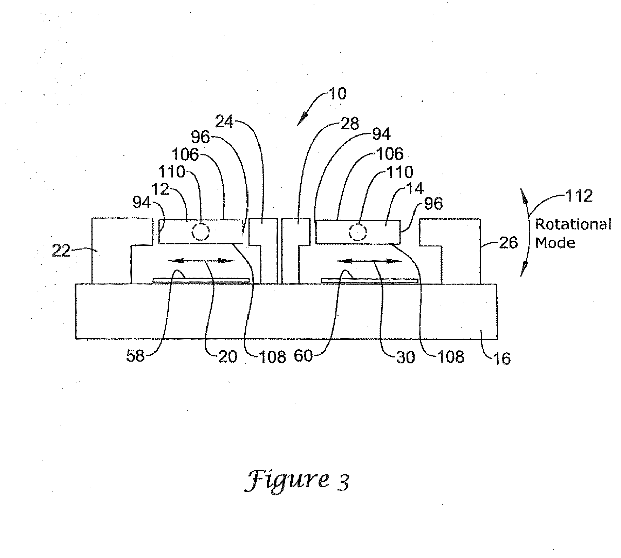

Figure 3 is a side schematic view showing the operation of the illustrative gyroscope 10 of Figures 1-2. As shown in Figure 3, each of the proof masses 12,14 can further include a thin plate structure adapted to overhang each corresponding sense electrode 58,60. Each of the proof masses 12,14 can include a top portion 106, a bottom portion 108, and a thickness therebetween.

As the proof masses 12,14 move back and forth along the drive axis 20,30 above the underlying support substrate 16, the distribution of weight uniformly across the length of the proof mass 12,14 will cause the proof mass 12,14 to rotate about its centroid 110 in a rotational mode, as indicated generally by arrow 112. Such rotation is induced in part based on the distribution of mass towards the ends 94,96 of the proof mass 12 away from the centroid 110. The magnitude and frequency characteristics of the rotation of the proof masses 12,14 in the rotational mode will depend at least in part on the moment of inertia of the proof mass 12,14 about the centerline C of the proof mass, which for a plane area, can be derived generally from the following formula:

$$(1) \quad I_y = \int x^2 dA;$$

where:

$I_y$ is the moment of inertia about the centerline of the proof mass; and
x is the coordinate for the differential area A between the proof mass ends.

The resulting force Fy on each proof mass 12,14, in turn, can be determined from the following formula:

$$(2) \quad F_y = \sqrt{K_y / I_y};$$

where:

Ky is the spring-constant for the proof mass.

Thus, in those instances in which the mass is distributed further away from the centroid 110, the moment of inertia about the centerline C of the proof masses 12,14 will tend to be greater, causing the proof masses 12,14 to rotate in the direction indicated by arrow 112.

A relatively large moment of inertia of the proof masses 12,14 will tend to decrease the frequency at which the proof masses 12,14 rotate in the rotational mode. In some instances, the rotational mode frequency caused by the distribution of mass towards the ends 94,96 of the proof masses 12,14 may lie within the control loop pass band used to drive the proof masses 12,14, introducing rotational harmonics in the drive system that can interfere with the drive electronics 42. In some applications, the drive electronics 42 may startup on the rotational mode, preventing the proof masses 12,14 from properly operating in their desired drive mode.

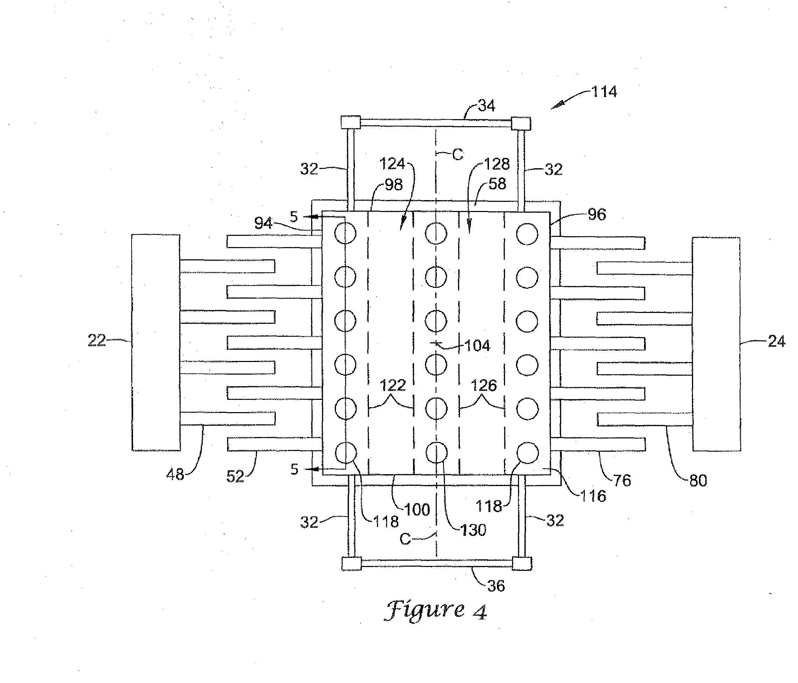

Referring now to Figure 4, a top schematic view of a portion of a proof mass structure 114 including a proof mass 116 with a number of non-uniformly dispersed holes or openings will now be described. Proof mass 116 is configured similar to proof mass 12 discussed above, with like elements labeled in like fashion. In the illustrative embodiment of Figure 4, however, the holes or openings 118 are located towards the ends 94,96 of the proof mass 116, with the interior area of the proof mass 116 being substantially free of such holes or openings. As demarcated generally by dashed lines 122, for example, a first interior area 124 of the proof mass 116 located between the centerline C and the first end 94 may be substantially free from any holes or openings. In similar fashion, and as further demarcated by dashed lines 126, a second interior area 128 of the proof mass 116 located between the centerline C and the second end 96 may be substantially free from any holes or openings. In such configuration, the distribution of mass in the proof mass 116 is concentrated more towards the center portion 104, thus reducing the moment of inertia of the proof mass 116 about the centerline C. If desired, a number of through-holes 130 disposed along the centerline C of the proof mass 116 can be provided to reduce aerodynamic drag as the proof mass 116 oscillates in the drive and sense modes, and to further decrease the overall mass of the proof mass structure 114.

During operation, the reduction in the moment of inertia of the structure due to the distribution of mass towards the center portion 104 increases the rotational frequency of the proof mass 116 in the rotational mode. In certain embodiments, the number, size and/or arrangement of the holes or openings 118 can be selected such that the rotational frequency of the proof mass 116 is above the control loop pass band of the drive system. Such an increase in the rotational frequency prevents startup and/or operation of the proof mass 116 in the wrong mode, ensuring proper stimulation and operation in the desired motor mode. If desired, other characteristics such as the materials used in fabricating the proof mass 116, the thickness and dimensions of the proof mass 116, the temperature and composition of the surrounding environment, the characteristics of the suspension springs 32 and comb fingers 52,76, etc. can also be selected to adjust the rotational frequency of the proof mass 116.

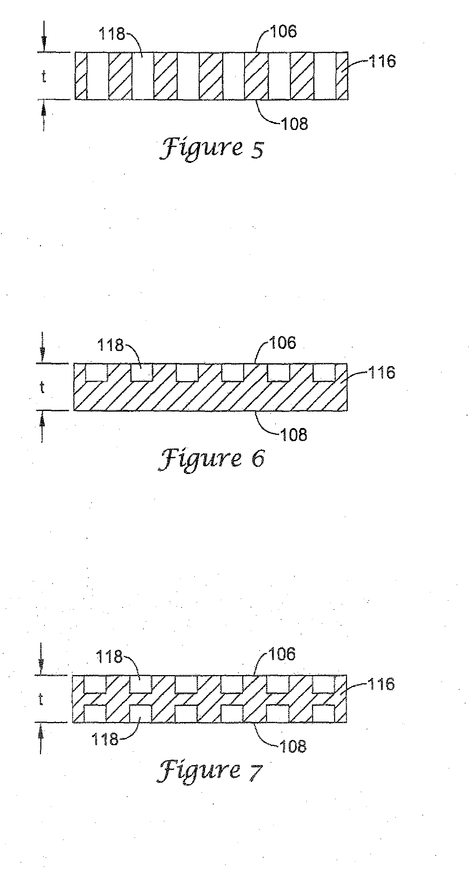

Figure 5 is a cross-sectional view of the proof mass 116 along line 5-5 in Figure 4, As can be seen in Figure 5, each of the holes or openings 118 may extend through the entire thickness t between the top and bottom portions 106,108 of the proof mass 116. Formation of the holes or openings 118 can be accomplished, for example, using a suitable etching process, wherein a patterned photomask is applied over the proof mass structure and a suitable wet and/or dry etchant is used to etch the holes or openings 118 through the thickness t. In addition to reducing the mass towards the ends 94,96 of the proof mass 116, the through-holes 118 can be further used to reduce aerodynamic drag in the drive and sense modes.

While the holes or openings 118 are shown extending through the entire thickness t of the proof mass 116, it should be understood that the holes or openings 118 may extend through only a portion of the proof mass 116. In one alternative embodiment depicted in Figure 6, for example, the holes or openings 118 may extend through only the top portion 106 of the proof mass 116, leaving intact the bottom portion 108 thereof. In another alternative embodiment depicted in Figure 7, the holes or openings 118 may extend through both the top and bottom portions 106, 108 of the proof mass 116, but do not extend through the entire thickness t of the proof mass 116. The depth at which the holes or openings 118 extend through the thickness t may be varied to impart a desired mechanical characteristic to the proof mass 116. Other factors such as the number, size, shape and/or arrangement of the openings 118 may be further selected to alter the mechanical characteristics of the proof mass 116.

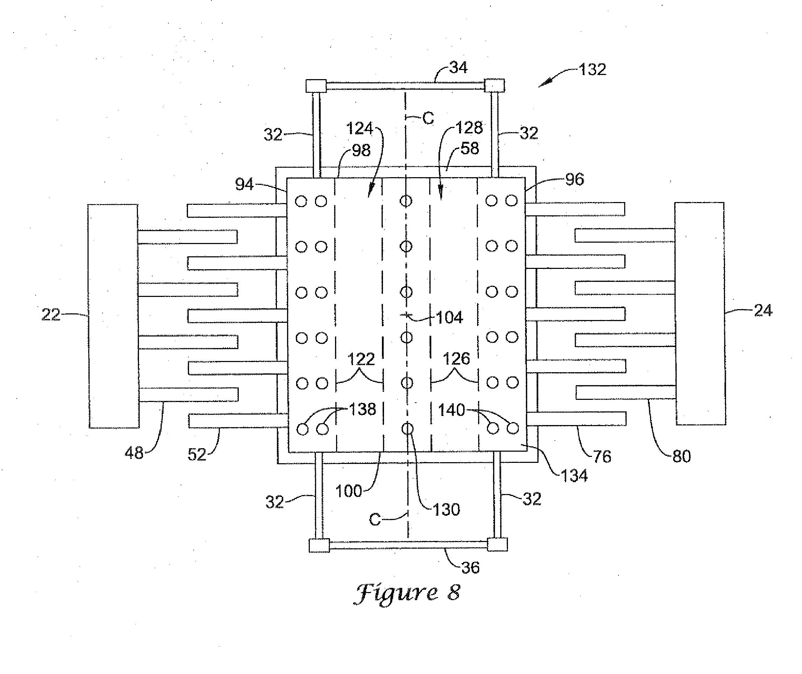

Figure 8 is a top schematic view of a portion of a proof mass structure 132 in accordance with another illustrative embodiment having a proof mass 134 with an array of holes or openings. Proof mass 134 is configured similar to proof mass 116 discussed above, with like elements labeled in like fashion. In the illustrative embodiment of Figure 8, however, the proof mass 134 may include an array of holes or openings arranged towards the ends 94,96 of the proof mass 134. A first array of holes or openings 138, for example, located near the first end 94 of the proof mass 134 to the left of interior area 124 can be provided to reduce the mass of the proof mass structure towards the first end 94 of the proof mass 134. In similar fashion, a second array of holes or openings 140 located near the second end 96 of the proof mass 134 to the right of interior area 128 can be provided to reduce the mass of the proof mass structure towards the second end 96 of the proof mass 134.

Each array of holes or openings 138,140 can be arranged in a two-dimensional array of columns and rows, with each hole or opening 138,140 within the array having a similar size and shape. Although each array is shown having two columns of six openings each, it should be understood that a greater or lesser number of rows and/or columns can be provided. As with other embodiments herein, the holes or openings 138, 140 may extend through the entire thickness of the proof mass structure, or may extend through only a portion thereof, if desired.

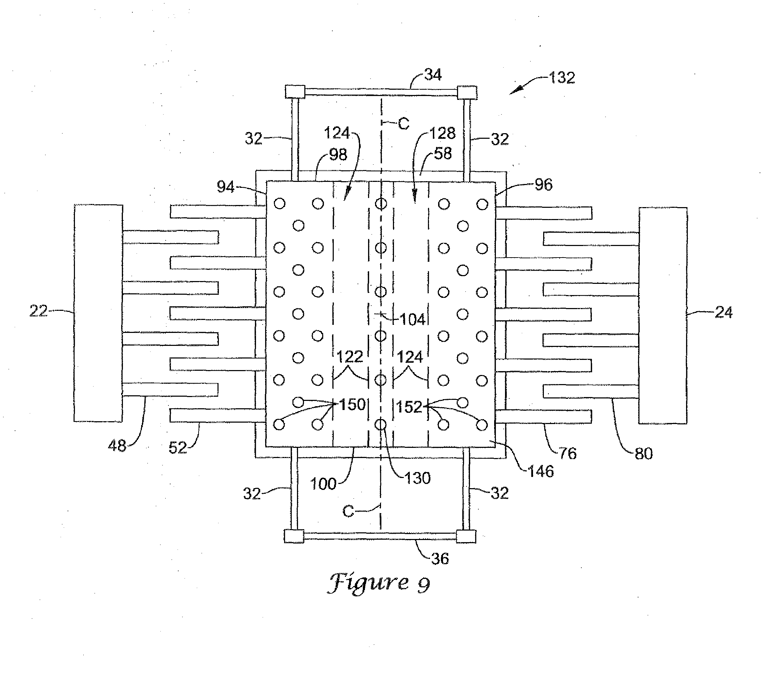

Figure 9 is a top schematic view of a portion of a proof mass structure 144 in accordance with another illustrative embodiment having a proof mass 146 with a staggered pattern or array of holes or openings. Proof mass 146 can be configured similar to proof mass 116 discussed above, with like elements labeled in like fashion. In the illustrative embodiment of Figure 9, however, the proof mass 146 may include a staggered pattern or array of holes arranged towards the ends 94,96 of the proof mass 146. A first staggered pattern or array of holes or openings 150, for example, located near the first end 94 of the proof mass 146 to the left of interior area 124 can be provided to reduce the mass of the proof mass 146 towards the first end 94 thereof. A second staggered pattern or array of holes or openings 152 located near the second end 96 of the proof mass 146 to the right of interior area 128, in turn, can be provided to reduce the mass of the proof mass 146 towards the second end 96 thereof. As further shown in Figure 9, the holes or openings 150,152 within each vertical column of the pattern or array can be staggered relative to the holes or openings 150,152 of each adjacent column.

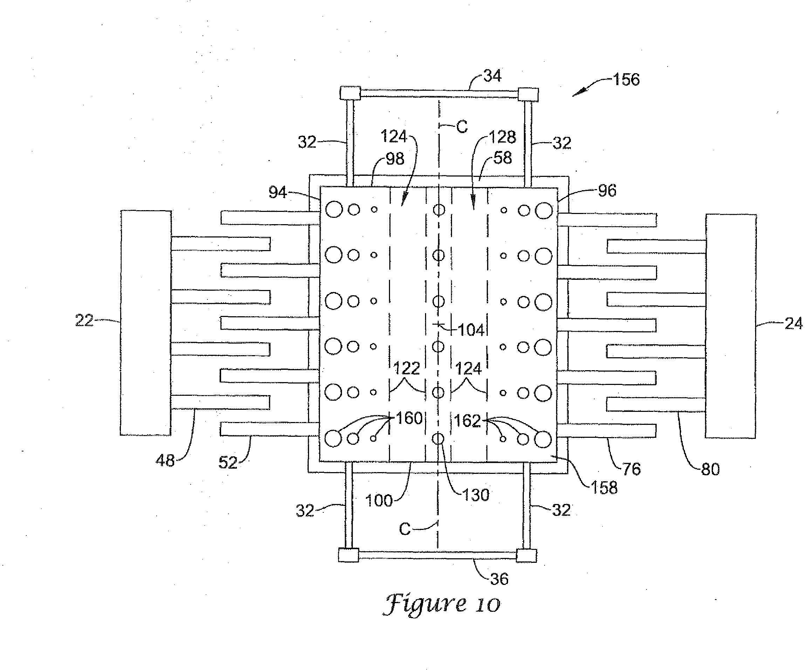

Figure 10 is a top schematic view of a portion of a proof mass structure 156 in accordance with another illustrative embodiment having a proof mass 158 with an array of holes or openings increasing in size towards each proof mass end. Proof mass 158 is configured similar to proof mass 116 discussed above, with like elements labeled in like fashion. In the illustrative embodiment of Figure 10, however, the size of the holes or openings may vary depending on the location of the hole or opening relative to the centerline C of the proof mass 158. A first array of holes or openings 160 located near the first end 94 of the proof mass 158 to the left of interior area 124 may vary in size, with the area of each hole or opening within each vertical column increasing in size towards the first end 94. In similar fashion, a second array of holes or openings 162 of the proof mass 158 located near the second end 96 of the proof mass 158 may vary in size, with the area of each hole or opening within each vertical column increasing in size towards the second end 96.

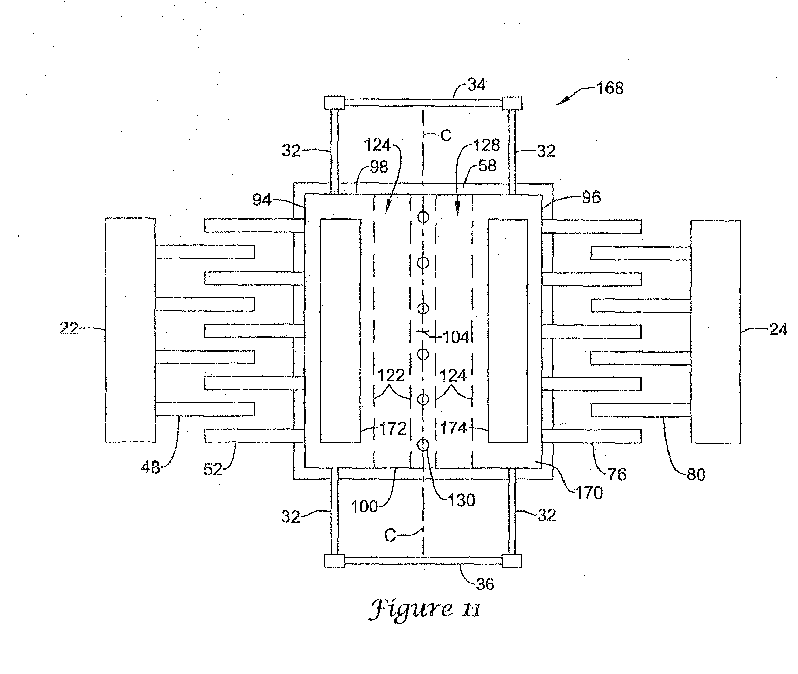

Figure 11 is a top schematic view of a portion of a proof mass structure 168 in accordance with another illustrative embodiment having a proof mass 170 with a number of slots. As shown in Figure 11, a first slot 172 located near the first end 94 of the proof mass 170 can be provided to reduce the mass of the proof mass 170 to the left of interior area 124. In similar fashion, a second slot 174 located near the second end 96 of the proof mass 170 can be provided to reduce the mass of the proof mass 170 to the right of interior area 128. In use, the slots 172,174 function in a manner similar to the holes or openings described herein, reducing the moment of inertia of the proof mass about the centerline C. As with other embodiments herein, the number, size, shape and/or arrangement of the slots 172,174 can be varied to impart a desired mechanical characteristic to the gyroscope. In some embodiments, for example, the slots 172, 174 can be configured to increase the rotational frequency of each proof mass 168 above the control loop pass band of the gyroscope to prevent proof mass startup on the rotational mode and to reduce the introduction of rotational harmonics into the drive and sense systems.

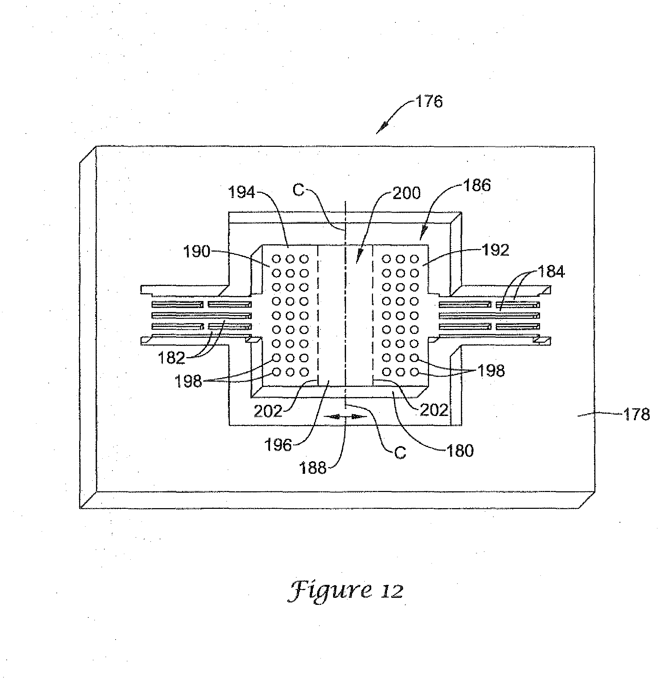

Referring now to Figure 12, a top schematic view of an illustrative MEMS-type accelerometer 176 including a proof mass with a number of non-uniformly dispersed holes or openings will now be described. As shown in Figure 12, the accelerometer 176 may include a stationary frame 178, a proof mass 180, and a number of beams 182,184 coupled between the frame 178 and the proof mass 180. During operation, the beams 182,184 can be configured to drive the proof mass 180 back and forth within the interior 186 of the frame 178 along a motor drive axis indicated generally by arrow 188.

The proof mass 180 can include a substantially planar structure having a first end 190, a second end 192, a first side 194, and a second side 196. In the illustrative embodiment depicted, the proof mass 180 can include a pattern or array of holes or openings 198 located at or near each end 190,192 of the proof mass 180, with the interior area 200 of the proof mass 180 demarcated generally by dashed lines 202 being substantially free of such holes or openings.

In use, and as with other embodiments described herein, the distribution of the holes or openings 198 towards the ends 190,192 of the proof mass 180 reduces the moment of inertia of the proof mass 180 about its centerline C, resulting in a concomitant increase in the frequency at which the proof mass 180 vibrates in its undesired vibrational modes. This increase in rotational frequency can be tuned such that the frequency of undesired vibrational modes are above the frequency of the control loop pass band used by the drive system to drive the vibrating beams 182,184, reducing the level of rotational harmonics that are introduced into the desired drive and sense modes.

While the holes or openings may be dispersed in a non-uniform manner away from the centerline and towards each end of the proof mass, in some applications it may be desirable to employ an opposite arrangement wherein the holes or openings are dispersed in a non-uniform manner towards the centerline of the proof mass and away from each end of the proof mass. In some applications, for example, it may be desirable to decrease the rotational frequency of the proof mass motion in the rotational mode to compensate for other undesired vibrational modes that can affect the operation of the MEMS device.

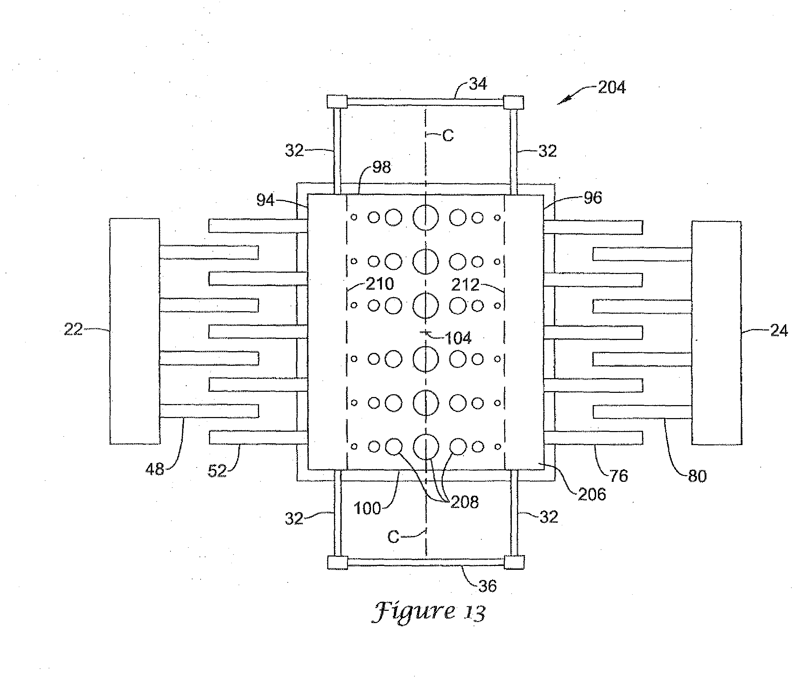

In one such embodiment depicted in Figure 13, for example, the proof mass structure 204 can include a proof mass 206 with an array of holes or openings 208 decreasing in size towards each proof mass end. Proof mass 206 is configured similar to proof mass 12 discussed above, with like elements labeled in like fashion. In the illustrative embodiment of Figure 13, however, the holes or openings 208 are located towards the centerline C of the proof mass 206, with the periphery of the proof mass 206 near the ends 94,96 thereof being substantially free of such holes or openings. As demarcated generally by dashed line 210, for example, the peripheral portion of the proof mass 206 located towards the first end 94 is substantially free from any holes or openings. In similar fashion, and as demarcated generally by dashed line 212, the peripheral portion of the proof mass 206 located towards the second end 96 is likewise substantially free from any holes or openings. In such configuration, the distribution of the mass in the proof mass 206 is concentrated more towards the ends 94,96 than at the centerline C. During operation, such decrease in mass at or near the centerline C results in a decrease in the rotational frequency of the proof mass 206 in its rotational mode.

The size of the holes or openings 208 may vary depending on the location of the hole or opening 208 relative to the centerline of the proof mass 206. In the illustrative embodiment of Figure 13, for example, the size of the holes or openings 208 may vary depending on the distance away from the centerline C, with the area of each hole or opening 208 within each vertical column decreasing in size towards the first and second ends 94,96. While an array of holes or openings 208 of varying size is depicted in Figure 13, other hole or opening configurations can also be employed, if desired.

Having thus described the several embodiments of the present invention, those of skill in the art will readily appreciate that other embodiments may be made and used which fall within the scope of the claims attached hereto. Numerous advantages of the invention covered by this document have been set forth in the foregoing description. It will be understood that this disclosure is, in many respects, only illustrative. Changes can be made with respect to various elements described herein without exceeding the scope of the invention.

**Claims**

1. A MEMS device, comprising:

   a substrate;
   at least one proof mass adjacent to the substrate, each proof mass having a number of ends, a number of sides, a thickness, and a centerline extending through a center portion of the proof mass perpendicular to a motor drive axis of the proof mass; and
   wherein each proof mass includes a plurality of holes or openings formed at least in part through said thickness, the holes or openings being non-uniformly dispersed within the proof mass.

2. The MEMS device of claim 1, wherein said non-uniformly dispersed holes or openings are located away from the centerline and towards each end of the proof mass.

3. The MEMS device of claim 1, wherein said non-uniformly dispersed holes or openings are located towards the centerline and away from each end of the proof mass.

4. The MEMS device of claim 1, wherein the mass of the proof mass at or near each end is less than the mass of the proof mass at the center portion.

5. The MEMS device of claim 1, wherein said plurality of holes or openings are disposed in a pattern or array at or near each end of the proof mass.

6. The MEMS device of claim 1, wherein said plurality of holes or openings are disposed in a staggered pattern or array at or near each end of the proof mass.

7. The MEMS device of claim 1, wherein said plurality of holes or openings extend through the entire thickness of the proof mass.

8. The MEMS device of claim 1, wherein said plurality of holes or openings extend through only a top portion of the proof mass.

9. The MEMS device of claim 1, wherein said plurality of holes or openings extend through only a top and bottom portion of the proof mass.

10. The MEMS device of claim 1, wherein the size of each hole or opening increases in a direction away from the centerline of the proof mass.

11. The MEMS device of claim 1, wherein said plurality of holes or openings comprises a number of slots.

12. The MEMS device of claim 1, further comprising a number of holes or openings disposed through the thickness of the proof mass along said centerline.

13. The MEMS device of claim 1, wherein said MEMS device is a gyroscope or accelerometer.

14. A MEMS device, comprising:

    a substrate;
    at least one sense electrode coupled to the substrate;
    at least one proof mass adjacent to the at least one sense electrode, each proof mass having a number of ends, a number of sides, a thickness, and a centerline extending through a center portion of the proof mass perpendicular to a motor drive axis of the proof mass;
    a plurality of holes or openings formed at least in part through the thickness of said proof mass, the holes or openings being dispersed away from the centerline and towards each end of the proof mass; and
wherein the distribution of the holes or openings is configured to increase the frequency of rotation of the proof mass about the centerline.

15. The MEMS device of claim 14, wherein the mass of the proof mass at or near each end is less than the mass of the proof mass at the center portion.

16. The MEMS device of claim 14, wherein said plurality of holes or openings are disposed in a pattern or array at or near each end of the proof mass.

17. The MEMS device of claim 14, wherein said plurality of holes or openings are disposed in a staggered pattern or array at or near each end of the proof mass.

18. The MEMS device of claim 14, wherein the size of each hole or opening increases in a direction away from the centerline of the proof mass.

19. The MEMS device of claim 14, wherein said plurality of holes or openings comprises a number of slots.

20. A MEMS device, comprising:

a substrate;
at least one sense electrode coupled to the substrate;
at least one proof mass adjacent to the at least one sense electrode, each proof mass having a number of ends, a number of sides, a thickness, and a centerline extending through a center portion of the proof mass perpendicular to a motor drive axis of the proof mass;
a first pattern or array of holes or openings formed at least in part through the proof mass thickness at or near a first end portion of the proof mass, the first pattern or array of holes or openings disposed adjacent a first interior portion of the proof mass containing no holes or openings; and
a second pattern or array of holes or openings formed at least in part through the proof mass thickness at or near a second end portion of the proof mass, the second pattern or array of holes or openings disposed adjacent a second interior portion of the proof mass containing no holes or openings.

Figure 1

*Figure 2*

*Figure 3*

Figure 4

*Figure 5*

*Figure 6*

*Figure 7*

*Figure 8*

Figure 9

Figure 10

Figure 11

Figure 12

Figure 13

**European Patent Office**

**EUROPEAN SEARCH REPORT**

Application Number

EP 07 10 0772

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/154400 A1 (JOHNSON BURGESS R [US] ET AL) 12 August 2004 (2004-08-12) <br> * page 1, paragraph 6 * <br> * page 2, paragraph 22 - paragraph 24 * <br> * pages 3,4, paragraphs 30,36,37,40-42 * <br> * figures 1,4-6,8 * <br> ----- | 1-20 | INV. <br> H03H9/24 <br> G01C19/56 |
| X | WO 03/014667 A (EADS DEUTSCHLAND GMBH [DE]; CONTI TEMIC MICROELECTRONIC [DE]; BAUER KA) 20 February 2003 (2003-02-20) <br> * abstract * <br> * page 2, line 25 - page 3, line 2 * <br> * page 4, line 8 - line 13 * <br> * page 8, line 17 - page 10, line 3 * <br> * figure 2 * <br> ----- | 1-20 | |

TECHNICAL FIELDS SEARCHED (IPC)

H03H
G01C
G01P

The present search report has been drawn up for all claims

| Place of search | Date of completion of the search | Examiner |
|---|---|---|
| The Hague | 6 June 2007 | Yosri, Samir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 10 0772

This annex lists the patent family members relating to the patent documents cited in the above-mentioned European search report.
The members are as contained in the European Patent Office EDP file on
The European Patent Office is in no way liable for these particulars which are merely given for the purpose of information.

06-06-2007

| Patent document cited in search report | | Publication date | Patent family member(s) | | Publication date |
|---|---|---|---|---|---|
| US 2004154400 | A1 | 12-08-2004 | AU | 2004210952 A1 | 26-08-2004 |
| | | | CA | 2515300 A1 | 26-08-2004 |
| | | | EP | 1597540 A1 | 23-11-2005 |
| | | | JP | 2006517301 T | 20-07-2006 |
| | | | WO | 2004072580 A1 | 26-08-2004 |
| WO 03014667 | A | 20-02-2003 | DE | 10139443 A1 | 06-03-2003 |

EPO FORM P0459

For more details about this annex : see Official Journal of the European Patent Office, No. 12/82